Europäisches Patentamt

**European Patent Office**

Office européen des brevets

(11) Publication number: **0 230 993**
A2

# (12) EUROPEAN PATENT APPLICATION

(21) Application number: 87100935.3

(22) Date of filing: 23.01.87

(51) Int. Cl.⁴: **C 08 J 7/18**
C 08 F 2/52, C 23 C 16/50,
C 08 G 85/00, B 05 D 1/00

(30) Priority: 24.01.86 IT 1918086

(43) Date of publication of application:
05.08.87 Bulletin 87/32

(84) Designated Contracting States: DE FR GB NL

(71) Applicant: AUSIMONT S.p.A.
31, Foro Buonaparte
I-20121 Milano (IT)

(72) Inventor: D'Agostino, Riccardo
191, via Dalmazia
I-70121 Bari (IT)

Cramarossa, Francesco
239, via Fanelli
I-70100 Bari (IT)

Fracassi, Francesco
6, via Virgilio
I-70019 Triggiano Bari (IT)

Illuzzi, Francesca
45/A via Imbriani
I-70054 Giovinazzo Bari (IT)

Caporiccio, Gerardo
13, via E. Filiberto
I-20149 Milan (IT)

(74) Representative: Barz, Peter, Dr. et al
Patentanwälte Dr. V. Schmied-Kowarzik Dipl.-Ing. G.
Dannenberg Dr. P. Weinhold Dr. D. Gudel Dipl.-Ing. S.
Schubert Dr. P. Barz Siegfriedstrasse 8
D-8000 München 40 (DE)

(54) Films, layers, tapes, plates and similar structures of metal or plastic materials coated with thin polyfluorocarbon films.

(57) The invention relates to films, layers, tapes, plates and similar structures of metal or plastic materials coated with thin polyfluorocarbon films and being characterized in that no other materials are interposed. The polyfluorocarbon films are adherent and not porous and have controlled wettability characteristics.

The polyfluorocarbons have the formula $(CF_2)_n$, wherein x has a value of from 0.3 to 2.0 and are directly obtained on the substrate by plasma polymerisation of gaseous streams of $C_2F_6$ and $H_2$, $C_2F_6$ and $C_2F_4$, $CF_4$ and $H_2$, $CF_4$ and $C_2F_4$ or $C_2F_4$.

The metal substrate can, for example, be Al, Cu, Fe, tin-coated Fe, Si, noble metals and alloys. The plastic substrates can, for example, be polytetrafluoroethylene, polypropylene, polyethylene, polyphenylene oxide, polycarbonate and neoprene.

EP 0 230 993 A2

**Description**

FILMS, LAYERS, TAPES, PLATES AND SIMILAR STRUCTURES OF METAL OR PLASTIC MATERIALS COATED
WITH THIN POLYFLUOROCARBON FILMS

The invention relates to films, layers, tapes, plates and similar structures of metal or plastic materials coated with thin, adherent and non-porous films of polyfluorocarbons with no other materials being interposed. The wettability of these films, layers, etc. can be controlled as desired from practically zero values which result in, for example, impermeability and passivation of the substrates, to values useful for different types of treatment such as, for example, the bonding to other materials and the chemical deposition of metals.

It is known that a non-porous coating of polytetrafluoroethylene cannot be directly applied onto a substrate of metal or of plastic materials. According to a known process the polytetrafluoroethylene film must, beforehand, undergo a cementation process, for example, by chemical treatment of the film with a solution of sodium naphthalene in tetrahydrofuran or with a solution of sodium amide in liquid ammonia. The surface of the polymer is, thus altered so as to render it wettable by an epoxy type adhesive which allows the polymer to be bonded onto the substrate. The use of these cementation solutions is not easy and causes environmental problems. In the case of the sodium naphthalene solution the process must be carried out in an inert medium, usually in dry nitrogen. Moreover, the films obtained must be treated immediately with the epoxy adhesive before their properties decay.

In another method of producing coatings or films of polytetrafluoroethylene on metal substrates, the substrate is coated with an aqueous emulsion of the polymer, followed by a drying step and a high temperature (380 to 440°C) sintering step. This method requires a laborious preliminary metal pickling procedure, for example, with concentrated HCl or with an abrasive.

In many cases the adhesion to the substrate is not sufficient. For this reason, it is necessary to admix the polymer emulsion with ingredients able to bind the polymer to the substrate. In such cases, the polytetrafluoroethylene film is endowed with a lower chemical and thermal resistance owing to the presence of the ingredients. Furthermore, such ingredients may cause toxicity problems.

An object of the present invention is to provide films, layers, tapes, plates and similar structures of metal or plastic materials coated with thin polyfluorocarbon films with no other materials being interposed which exhibit excellent adherence to the substrate, are free of porosity and which have controlled wettability characteristics.

Another object is to provide a process for producing these thin films which overcomes the drawbacks of the prior art. In accordance with the present invention the first object is achieved by means of films, layers, tapes, plates and similar structures of metal or plastic materials coated with thin films of polyfluorocarbons and characterized in that no other materials are interposed. The polyfluorocarbon films are adherent and non-porous and have controllable wettability characteristics. The polyfluorocarbons have the formula $(CF_x)_n$, wherein x has a value of from 0.3 to 2.0 and are obtained by plasma-polymerisation of gaseous streams of $C_2F_6$ and $H_2$, $C_2F_6$ and $C_2F_4$, $CF_4$ and $H_2$, $CF_4$ and $C_2F_4$ or of $C_2F_4$.

Suitable metal substrates comprise, for example, Al, Cu, Fe, tin-coated Fe, Si, noble metals and alloys such as steel and brass. A particularly preferred metal substrate is aluminium.

Suitable polymeric substrates comprise, for example, polytetrafluoroethylene, polypropylene, polyethylene, polyphenylene oxide, polycarbonate and neoprene. A particularly preferred polymeric substrate is polytetrafluoroethylene.

The polyfluorocarbons having formula $(CF_x)_n$ are known and are obtained by plasma-polymerisation of gaseous streams of $C_2F_4$ or of freons with $H_2$. They are, for example, described in the papers by E. Kay, J. Coburn and A. Dilks in "Topics in Current Chemistry", III, Springer Verlag, Berlin 1980, page 1; N. Morosoff, H. Yasuda, E.S. Brandt, C.N. Reilly in J. Appl. Polym. Sci., 23, 1003 (1979; ibidem 23, 3449 (1979); ibidem 23, 3471 (1979); R. d'Agostino, P. Capezzuto, G. Bruno, F. Cramarossa in Pure and Applied Chemistry, 57, 1287 (1985).

When x is close to 2, the polymers have a structure resembling that of polytetrafluoroethylene. When x is close to 0.3, the polymer is highly crosslinked.

The adherence of the film to the substrate is very good, for example, values are usually achieved which are within the range of from 30 to 50 $kg/cm^2$ when the substrate is aluminium and from 10 to 30 $kg/cm^2$ when the substrate is polytetrafluoroethylene.

The wettability, measured as $\gamma_c$ (critical surface tension) is usually within the range of from 18 to 40 dynes.$cm^{-1}$. Values of $\gamma_c$ within the range of from 18 to 22 correspond to practically zero wettability and are obtained with polyfluorocarbons $(CF_x)_n$, wherein x has a value of from about 1.7 to 2. Values of $\gamma_c$ within the range of from 23 to 40 correspond to properties of partial or complete wettability suitable for further treating the structure by, for example bonding it to other materials, and are obtained with polyfluorocarbons $(CF_x)_n$, wherein x has a value of from 0.3 to about 1.4.

The non-wettable coatings can also be bonded to other materials by means of epoxy resins.

The thickness of the polyfluorocarbon film is, usually, within the range of from 100 Å to 3 microns.

Of particular interest from the viewpoint of the application are metal substrates coated with non-wettable polyfluorocarbon films and substrates of non-wettable polymers coated with films of wettable polyfluorocarbons. Examples of "non-wettable polymers" are polytetrafluoroethylene, polypropylene, polyethylene, polyphenylene oxide, polycarbonate and neoprene.

In the first case, the metal substrates are coated with polyfluorocarbons $(CF_x)_n$, wherein x has a value of from about 1.7 to 2 0, which have a critical surface tension of from 18 to 22. Metal structures with impermeable, passivating, insulating coatings are, thus, obtained. An interesting application of such coated structures is the production of bags for the vacuum preservation of coffee, made of aluminium films coated with polyfluorocarbons having such characteristics. The thickness of the polyfluorocarbon coating in such bags is generally within the range of from 0.5 to 2 microns.

In the second case, the substrates of non-wettable polymers are coated with polyfluorocarbons $(CF_x)_n$, wherein n has a value of from about 0.3 to about 1.4, and the critical surface tension is of from about 23 to about 34 dynes.$cm^{-1}$. Application in the form of, for example, writing, colours or depositing metals is possible on these coated structures. The same coated structures can also be bonded, by means of conventional bonding agents, onto other surfaces such as, for example, metals, rubbers or technopolymers.

The present invention also relates to a process for coating films, layers, tapes, plates and similar structures of metal or plastic materials with a thin film of the above-said polyfluorocarbons. This process is characterized in that a gaseous stream of $C_2F_6$ and $H_2$, $C_2F_6$ and $C_2F_4$, $CF_4$ and $H_2$, $CF_4$ and $C_2F_4$ or $C_2F_4$ is passed through a reactor equipped with two electrodes, one of which is connected to a radio frequency current generator, the other being grounded. The substrate is placed on one of the electrodes. The pressure of the gaseous stream is within the range of from 0.1 to 2 Torr. A power density of at least 1 $W/cm^2$ is applied in such a way as to cause the formation of the plasma and the consequent polymerisation of the fluorocarbons directly on the substrate, which is maintained at a temperature of from 20 to 120°C. The substrate temperature can be maintained at these values by circulating inside the electrodes a liquid coming from a temperature control unit.

The power density is, preferably, comprised within the range of from 1 to 10 $W/cm^2$ The two electrodes are, preferably, parallel to each other.

The temperature of the substrate is, preferably, kept within the range of from 40 to 100°C.

These preferred conditions allow very high polymerisation rates of up to 0.3 to 0.4 microns per minute.

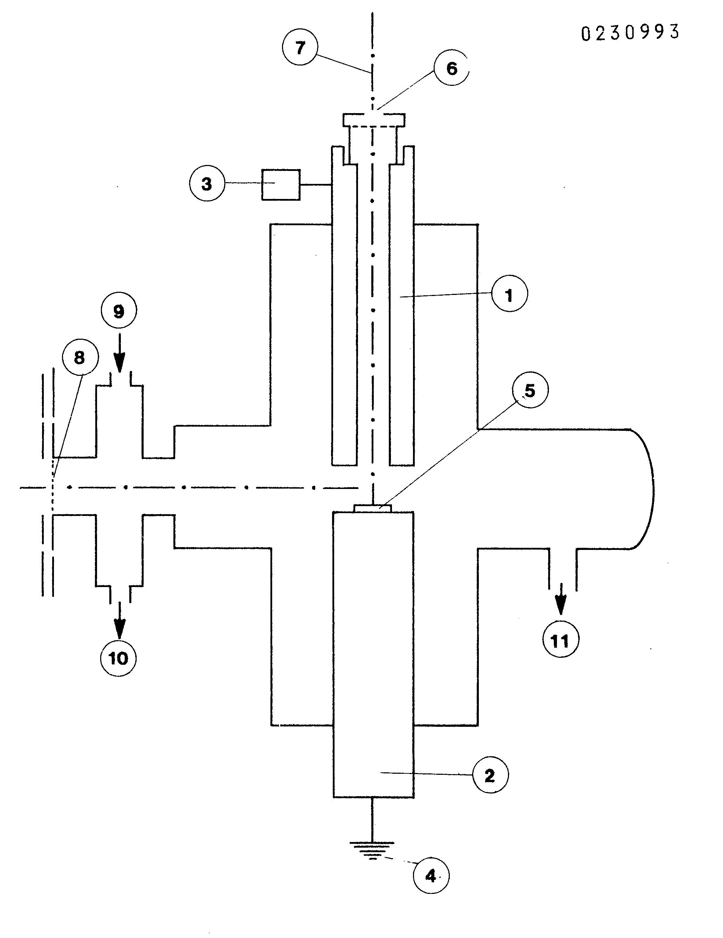

In the following, an example of an apparatus suitable for carrying out the process is described with reference to the attached figure.

The reactor, of pyrex glass, is provided with two inner, parallel-plate electrodes 1 and 2. The potential-fed electrode is the upper electrode 1, connected to a radio frequence generator 3. The other electrode 2 is grounded in 4. The electrodes are temperature controlled by circulating a liquid mixture coming from a temperature controller unit not shown in the figure. The substrate 5 to be coated rests on the lower electrode 2. The upper electrode is bored and provided with an upper sapphire window 6 to allow the passage of a laser light beam 7 serving to measure the thickness of the film when the substrate 5 is reflecting, by interferometry. On the left-hand side of the apparatus a sapphire window 8 is provided for the purpose of measuring, by spectroscopy, the light emission of the discharge. The gaseous stream enters from 9 and its pressure is measured in 10. The line 11 leads to a pump not shown. The radio frequency power generator 3 is of conventional type, provided with a system to calibrate the impedances and with a power meter.

When the substrate is not reflecting, the thickness of the film is determined by a gravimetric method.

The stoichiometry of polyfluorocarbon $(CF_x)_n$ is determined by XPS analysis.

Preferably, a gaseous mixture of $C_2F_6$ and $H_2$, containing from 10 to 80% by volume of $H_2$, is used. Increasing concentrations of $H_2$ in the mixture result in an increase in polymer crosslinking. With an $H_2$ percentage comprised between 10 and 25%, a fluoropolymer $(CF_2)_n$ is obtained in which x ranges from 1.7 to 2 0. With an $H_2$ percentage comprised between 30 and 80%, a fluoropolymer $(CF_x)_n$ is obtained in which x ranges from 0.3 to 1.4.

The rate of deposition of the polymer on the substrate varies as a function of the substrate temperature, the pressure and the composition of the gaseous mixture. Low substrate temperatures, relatively high pressures and $H_2$ percentages in the mixture $C_2F_6$-$H_2$ within the range of from 20 to 60% favour high deposition rate values. This rate can range from values close to 0 up to about 0.3 to 0.4 microns per minute.

The duration of the electrical discharge is, generally, from 2 to 20 minutes.

The following examples illustrate the invention.

EXAMPLE 1

The reactor shown in the figure is used. The radio frequency electrical generator has a frequency of 27 MHz and a maximum power output of 80 W. The electrodes are parallel to each other and circular and have a diameter of 3 cm. The distance between the two electrodes is 3 cm. The upper electrode is connected to the current generator, the lower electrode is grounded.

The experimental procedure is as follows:

a) Thin plates of polished aluminium or of polytetrafluoroethyl having the following dimensions:

$20 \times 20 \times 1$ mm are washed in an ultrasonic bath with various solvents (acetone, $CCl_4$, petroleum ether);

b) The plates are placed on the lower electrode in the reactor. For aluminium, monitoring of the film deposition rate is possible by laser interferometry, whereby a laser beam is made to impinge on the substrate. The temperature of the electrode is controlled within the range of from 20 to 120°C;

c) The composition and the total flow rate of the gaseous mixture is adjusted by rotameter flowmeters. The pressure is controlled by a membrane valve interposed between the reactor and the rotary vacuum pump. The pressure is read by an MKS Baratron connected to the reactor;

d) The electrical discharge is switched on and the impedance is regulated so as to keep the reflected power at a minimum and the direct power at a maximum;

e) The film growth on Al is monitored by the laser interferometric trace on a recorder connected to a photodiode. When the required thickness has been reached or the desired time has elapsed. the electrical discharge is turned off:

f) The film-coated substrates are removed from the reactor. The thickness of the polymeric film on the polytetrafluoroethylene plate is measured by a balance to the 6th decimal digit, the specific gravity of the deposited material being known;

g) The XPS spectrum of the film on the plates allows the chemical structure of the coating to be determined. The adherence is measured by the "lap shear" method. The wettability is determined by measuring the contact angles with various solvents and the value of $\gamma_c$ is obtained graphically according to the known procedure.

In this example the support consists of Al, the gaseous mixture fed comprises 20% of $H_2$ and 80% of $C_2F_6$ by volume, the total gaseous stream flow rate is 30 $cm^3$ (STP) per minute, the pressure is 1 Torr, the power supplied by the generator is 40 W, the temperature of the substrate is $40°C$ and the discharge time is 5 minutes.

The coating obtained has a thickness of 1 micron, its composition is $(CF_{1.8})_n$, the bonding strength of the film to the substrate is 50 kg/cm$^2$ and its $\gamma_c$ is 18 dynes.cm$^{-1}$.

## EXAMPLE 2

The support consists of polytetrafluoroethylene, the gaseous mixture fed comprises 70% of $H_2$ and 30% of $C_2F_6$ by volume, the total gaseous stream flow rate is 30 $cm^3$ (STP) per minute, the pressure is 1 Torr, the power supplied by the generator is 60 W, the temperature of the substrate is $40°C$ and the discharge time is 20 minutes.

The coating obtained has a thickness of 0.5 micron, its composition is $(CF_{0.3})_n$, the $\gamma_c$ of the film is 34 dynes.cm$^{-1}$ and the bonding strength of the film to the substrate is 20 kg/cm$^2$.

## EXAMPLE 3

The support consists of polytetrafluoroethylene, the gaseous mixture fed comprises 50% of $H_2$ and 50% of $C_2F_6$ by volume, the total gaseous stream flow rate is 30 $cm^3$ (STP) per minute, the pressure is 1 Torr, the power supplied by the generator is 60 W, the temperature of the substrate is $40°C$ and the discharge time is 10 minutes.

The coating obtained has a thickness of 0.7 micron, its composition is $(CF_{0.7})_n$. the $\gamma_c$ of the film is 24 dynes.cm$^{-1}$ and the bonding strength of the film to the substrate is 10 kg/cm$^2$.

## EXAMPLE 4

The support consists of aluminium, the gaseous mixture fed comprises 20% of $H_2$ and 80% of $C_2F_6$ by volume, the total gaseous stream flow rate is 30 $cm^3$ (STP) per minute and the pressure is 1 Torr. The apparatus used differs from that of example 1 in that the lower electrode is connected to the radio frequency generator. The power is 40 W, the temperature of the substrate is $40°C$ and the discharge time is 10 minutes.

The coating obtained has a thickness of 1 micron, its composition is $(CF_{1.5})_n$, the bonding strength of the film to the substrate is 50 kg/cm$^2$ and its $\gamma_c$ is 22 dynes.cm$^{-1}$.

## EXAMPLE 5

The support consists of aluminium, the gaseous mixture fed comprises 80% of $H_2$ and 20% of $C_2F_6$ by volume, the total gaseous stream flow rate is 30 $cm^3$ (STP) per minute and the pressure is 1 Torr. The apparatus used is identical to that of example 1. The power supplied by the generator is 80 W, the temperature of the substrate is $100°C$ and the discharge time is 30 minutes.

The coating obtained has a thickness of 0.3 microns, its composition is $(CF_{0.4})_n$, the bonding strength of the film to the substrate is 30 kg/cm$^2$ and its $\gamma_c$ is 34 dynes.cm$^{-1}$.

## EXAMPLE 6

The support consists of polytetrafluoroethylene, the gaseous mixture fed comprises 20% of $H_2$ and 80% of $C_2F_6$ by volume, the total gaseous stream flow rate is 30 $cm^3$ (STP) per minute and the pressure is 1 Torr. The apparatus used is identical to that of example 1. The power supplied by the generator is 60 W, the temperature of the substrate is $40°C$ and the discharge time is 1 minute.

The coating obtained has a thickness of 0.1 microns. its composition is $(CF_2)_n$, the bonding strength of the film to the substrate is 50 kg/cm$^2$ and its $\gamma_c$ is 18 dynes.cm$^{-1}$.

## Claims

1. Films, layers, tapes, plates and similar structures of metal or plastic materials coated with thin polyfluorocarbon films, characterized in that no other materials are interposed; the polyfluorocarbon films are adherent and non-porous and have controlled wettability characteristics; the polyfluorocarbons have the formula $(CF_2)_n$, wherein x has a value of from 0.3 to 2.0 and are obtained directly on the substrate by plasma polymerisation of gaseous streams of $C_2F_6$ and $H_2$, $C_2F_6$ and $C_2F_4$, $CF_4$ and $H_2$, $CF_4$ and $C_2F_4$ or of $C_2F_4$.

2. Films, layers, tapes, plates and similar metal structures according to claim 1, characterized in that the metal substrate is selected from Al, Cu, Fe, tin-coated Fe, Si, noble metals and alloys.

3. Films, layers, tapes, plates and similar metal structures according to claim 2, characterized in that the metal is aluminium

4. Films, layers, tapes, plates and similar structures according to claim 1, characterized in that the plastic materials are selected from polytetrafluoroethylene, polypropylene, polyethylene, polyphenylene oxide, polycarbonates and neoprene.

5. Films, layers, tapes, plates and similar structures according to claim 4, characterized in that the plastic material is polytetrafluoroethylene.

6. Films, layers, tapes, plates and similar metal structures according to one more of claims 1 to 3, characterized in that, in the polyfluorocarbon x has a value of from about 1.7 to 2.0 and the polyfluorocarbon has a critical surface tension of from 18 to 22 $dynes.cm^{-1}$.

7. Films, layers, tapes, plates and similar structures of plastic materials according to one or more of claims 1, 4 and 5, characterized in that, in the polyfluorocarbon x has a value of from 0.3 to 1.4 and the polyfluorocarbon has a critical surface tension of from about 23 to about 34 $dynes.cm^{-1}$.

8. A process for coating films, layers, tapes, plates and simliar structure of metal or plastic materials with a thin polyfluorocarbon film according to one or more of claims 1 to 7, characterized in that a gaseous stream of $C_2F_6$ and $H_2$, $C_2F_6$ and $C_2F_4$, $CF_4$ and $H_2$, $CF_4$ and $C_2F_4$ or of $C_2F_4$ is passed through a reactor provided with two electrodes, one of which is connected to a radio frequency generator and the other is grounded; the substrate is placed on one of the electrodes; the pressure of the gaseous stream is maintained within the range of from 0.1 to 2 Torr; a power density of at least 1 $W/cm^2$ is applied, a plasma being, thus, generated, and polymerisation of the fluorocarbons being caused directly on the substrate, the temperature of which is maintained within the range of from 20 to 120°C

9. A process according to claim 8, characterized in that the power density is within the range of from 1 to 10 $W/cm^2$

10. A process according to claim 8 or 9, characterized in that the two electrodes are parallel to each other.

11. A process according to one or more of claims 8 to 10, characterized in that the temperature of the substrate is maintained within the range of from 40 to 100°C.

12. A process according to one or more of claims 8 to 11, characterized in that a gaseous stream of $C_2F_6$ and $H_2$ is used, the percentage of $H_2$ by volume being within the range of from 10 to 80%.

13. Bags to store coffee under vacuum, characterized in that they are constituted of films of aluminium coated with thin films of polyfluorocarbons having the formula $(CF_x)_n$. wherein x has a value of from about 1.7 to 2, said thin polyfluorocarbon films having a critical surface tension of from 18 to 22 $dynes.cm^{-1}$

and being formed on aluminium films by plasma polymerisation of gaseous streams of $C_2F_6$ and $H_2$, $C_2F_6$ and $C_2F_4$, $CF_4$ and $H_2$, $CF_4$ and $C_2F_4$ or of $C_2F_4$.

0230993